# EUROPÄISCHE PATENTSCHRIFT

(11) **EP 3 997 969 B1**
(45) Veröffentlichungstag und Bekanntmachung des Hinweises auf die Patenterteilung: **23.09.2026**
(21) Anmeldenummer: 20771448.6
(22) Anmeldetag: 25.08.2020
(51) Int. Cl.: H05K 5/00

(54) **ELEKTRONISCHES GERÄT**
ELECTRONIC DEVICE
APPAREIL ÉLECTRONIQUE

(30) Priorität: 29.08.2019 AT 507502019
(43) Veröffentlichungstag der Anmeldung: 18.05.2022
(73) Patentinhaber: MELECS EWS GmbH, 7011 Siegendorf (AT); Pollmann International GmbH, 3822 Karlstein (AT)
(72) Erfinder: GIRCZ, Patrick, 1030 Wien (AT); MAYER, Martin Johann, 2651 Reichenau an der Rax (AT); STEINDL, Dietmar, 3843 Dobersberg (AT); STOCKLASSER, Markus, 3841 Windigsteig (AT)
(74) Vertreter: Maier, Daniel Oliver
(86) Internationale Anmeldenummer: PCT/EP2020/073757
(87) Internationale Veröffentlichungsnummer: WO 2021/037854

(56) Entgegenhaltungen:
- WO-A1-2020/182662
- WO-A1-2020/239666
- DE-A1- 102006 018 457
- DE-A1- 102015 200 867
- US-A1- 2005 057 902
- US-A1- 2005 281 009

## Beschreibung

Die Erfindung bezieht sich auf ein elektronisches Gerät, insbesondere Steuergerät, mit zumindest einer bestückten Trägerplatte.

Insbesondere in der Fahrzeugelektronik besteht häufig die Notwendigkeit, Geräte mit Steuerelektronik in ein Fahrwerk, in einen Motor, in ein Getriebe oder in eine Pumpe etc. zu integrieren, um begrenzte Einbauräume möglichst gut zu nutzen und um Leitungswege kurz zu halten. Zugleich muss von den Geräten abgegebene Wärme aus den Geräten abgeführt werden, um Schäden aufgrund von übermäßiger thermischer Belastung und Beanspruchung zu vermeiden.

Weiterhin ist ein Schutz der Geräte vor mechanischen Beschädigungen **(z.B.** aufgrund von Stößen) wichtig.

Aus dem Stand der Technik ist beispielsweise die DE 10 2006 018 457 A1 bekannt, in welcher eine elektronische Schaltungsvorrichtung mit einer Trägerplatte und Bestückungselementen, welche mit einem aus Harz geformten Gehäuse ummantelt sind, gezeigt ist.

Weiterhin offenbart die US 2005/0281009 A1 eine elektronische Schalteinheit mit einer Platine, welche über gekrümmte Steckverbinder mit einem Koppler verbunden ist. Die Platine, die Steckverbinder sowie eine auf der Platine angeordnete elektronische Komponente sind mit einer schützenden Beschichtung aus Spritzgussmaterial umhüllt.

In der US 2005/0057902 A1 ist darüber hinaus eine elektronische Steuereinheit mit einer Trägerplatte dargestellt, welche über gekrümmte Steckverbinder mit einer Verbindungseinheit gekoppelt ist. Die Trägerplatte und die Steckverbinder sind in einen mit Gussmaterial abgedeckten Körper eingebettet. Ein auf der Trägerplatte angeordneter Drucksensor ist mittels eines eigenen Gehäuses eingehaust.

Ferner zeigt die DE 10 2015 200 867 A1 eine Elektronikeinheit mit einer bestückten Trägerplatte, welche über Verbindungsstecker mit einem Elektromotor gekoppelt ist. Die Trägerplatte ist mit einem Umspritzungsbereich ummantelt. Zwischen dem Umspritzungsbereich und dem Elektromotor ist ein Kühlkörper angeordnet.

Aus dem Stand der Technik ist beispielsweise auch die WO 2017/084949 A1 bekannt, welche eine elektrische Maschine mit einem Gehäuse zeigt. Ein Gehäusedeckel weist einen mit einem thermoplastischen Werkstoff ummantelten Kern auf. In den Kern, welcher in Duroplast ausgebildet ist, ist eine bestückte Trägerplatte eingebettet.

Dieser Ansatz weist in seiner bekannten Form den Nachteil auf, dass für Wärmeabführung und mechanischen Schutz zwei aus unterschiedlichen Werkstoffen gefertigte Komponenten, nämlich eine thermoplastische Hülle und der duroplastische Kern, eingesetzt sind. Weiterhin verursacht der duroplastische Kern einen hohen Aufwand bei einer Entsorgung oder einer Wiederaufbereitung der Maschine.

Der Erfindung liegt daher die Aufgabe zugrunde, ein gegenüber dem Stand der Technik vereinfachtes, kompaktes und umweltschonendes elektronisches Gerät anzugeben.

Erfindungsgemäß wird diese Aufgabe gelöst mit einem elektronischen Gerät der eingangs genannten Art, bei dem ein wärmeleitfähiges Kunststoffgehäuse an die zumindest eine Trägerplatte sowie an zumindest ein erstes Bestückungselement angrenzend angeordnet ist, wobei das Kunststoffgehäuse zumindest eine Trägerplatten-Grundfläche und eine Trägerplatten-Deckfläche sowie eine erste Bestückungselement-Deckfläche und eine erste Bestückungselement-Mantelfläche kontaktiert.

Durch an die Trägerplatte und das erste Bestückungselement unmittelbar angrenzende Anordnung des Kunststoffgehäuses kann auf Einbettung der Trägerplatte in einen duroplastischen Kern verzichtet werden, wodurch bei einem Recycling des elektronischen Geräts Vereinfachungen erzielt werden. Weiterhin bewirkt das Kunststoffgehäuse einerseits eine effektive Wärmeabführung von der Trägerplatte in deren Umgebung und schützt andererseits die Trägerplatte vor mechanischen Belastungen.

Da innerhalb des Kunststoffgehäuses keine zusätzliche Komponente zur Wärmeabführung von der Trägerplatte vorgesehen sein muss, wird ein vorhandenes Bauraumbudget platzsparend genützt. Weiterhin weist das elektronische Gerät dadurch eine geringe Masse auf.

Erfindungsgemäß wird eine Oberfläche des Kunststoffgehäuses einem aus der zumindest einen Trägerplatte und dem zumindest ersten Bestückungselement gebildeten Dickenverlauf folgend ausgeführt.

Durch diese Maßnahme wird eine möglichst große Oberfläche des Kunststoffgehäuses und somit eine Steigerung der Wärmeabführung erzielt.

Eine günstige Lösung wird erreicht, wenn das Kunststoffgehäuse zumindest eine Ausnehmung aufweist, mittels welcher die zumindest eine Trägerplatte im Bereich der zumindest einen Ausnehmung freigelegt ist.

Durch diese Maßnahme wird eine Inspektions- und/oder Wartungsöffnung erzielt.

Hierbei ist es auch hilfreich, wenn im Bereich der zumindest einen Ausnehmung eine Leuchtanzeige auf der zumindest einen Trägerplatte angeordnet ist.

Dadurch können Betriebszustände angezeigt werden und sind über die Ausnehmung von einem Bediener bewertbar.

Weiterhin ist es günstig, wenn das Kunststoffgehäuse in einem Polymer-Werkstoff ausgebildet ist.

Hierbei ist es besonders hilfreich, wenn der Polymer-Werkstoff als Thermoplast ausgeführt ist.

Dadurch weist das Kunststoffgehäuse eine hohe Resistenz gegenüber mechanischen Belastungen sowie gegenüber einer Einwirkung von Feuchtigkeit, von Wasser und von aggressiven Substanzen auf. Weiterhin haben thermoplastische Werkstoffe den Vorteil einer hohen Wärmeleitfähigkeit und können bei sehr hohen, aber auch bei sehr niedrigen Betriebstemperaturen des elektronischen Geräts eingesetzt werden.

Eine günstige Lösung wird erreicht, wenn das Kunststoffgehäuse einen Kühlkörper aufweist.

In diesem Zusammenhang ist es auch vorteilhaft, wenn der Kühlkörper einstückig mit dem Kunststoffgehäuse ausgebildet ist.

Durch diese Maßnahme kann auf separate Kühlvorrichtungen verzichtet werden.

Eine vorteilhafte Ausgestaltung erhält man, wenn die zumindest eine Trägerplatte über zumindest einen elektrischen ersten Kontakt mit einer elektrischen Maschine verbindbar ist.

Dabei ist es günstig, wenn die elektrische Maschine als fluidischer Aktuator ausgebildet ist.

Dadurch kann von dem ersten Bestückungselement abgegebene Wärme über das Kunststoffgehäuse unmittelbar an ein in der elektrischen Maschine strömendes Fluid abgeführt werden, wodurch eine besonders starke Kühlwirkung auf das elektronische Gerät erzielt wird.

Nachfolgend wird die Erfindung anhand eines Ausführungsbeispiels näher erläutert.

Es zeigt beispielhaft:

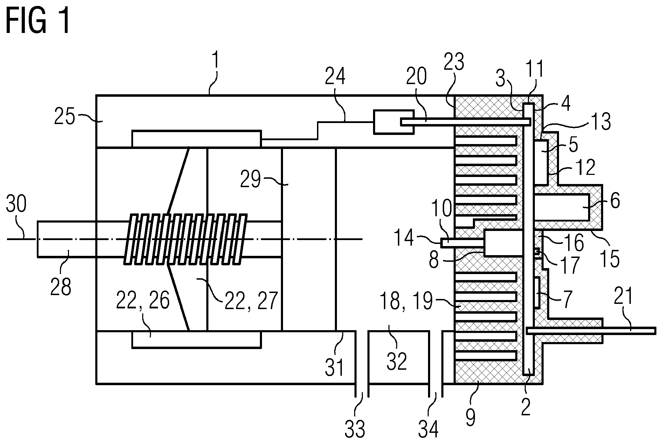

- Fig. 1:: Einen schematischen Seitenriss einer beispielhaften Ausführungsvariante eines mit einem fluidischen Aktuator gekoppelten, erfindungsgemäßen elektronischen Geräts in geschnittener Darstellung.

Fig. 1 zeigt eine beispielhafte Ausführungsvariante eines erfindungsgemäßen elektronischen Geräts in geschnittener Darstellung, das mit einer als fluidischer Aktuator ausgebildeten elektrischen Maschine 1 verbunden ist. Das elektronische Gerät ist als Steuergerät (Electronic Control Unit, ECU) für einen in Fig. 1 nicht gezeigten Teleskopstoßdämpfer einer Radaufhängung eines Kraftfahrzeugs vorgesehen, welcher mit der Maschine 1 verbunden ist.

Das elektronische Gerät weist eine Trägerplatte 2 mit einer Trägerplatten-Grundfläche 3 und einer Trägerplatten-Deckfläche 4 auf. Auf der Trägerplatten-Deckfläche 4 sind ein erstes Bestückungselement 5, ein zweites Bestückungselement 6 sowie ein drittes Bestückungselement 7 vorgesehen. Auf der Trägerplatten-Grundfläche 3 ist weiterhin ein viertes Bestückungselement 8 angeordnet, welches als zylindrischer Drucksensor ausgebildet ist.

Die Trägerplatte 2 ist also beidseitig bestückt.

Die Trägerplatte 2 sowie das erste Bestückungselement 5, das zweite Bestückungselement 6, das dritte Bestückungselement 7 und das vierte Bestückungselement 8 sind von einem wärmeleitfähigen Kunststoffgehäuse 9 ummantelt, wobei eine Messsonde 10 des vierten Bestückungselements 8 aus dem Kunststoffgehäuse 9 herausragt.

Das Kunststoffgehäuse 9 ist an die zumindest eine Trägerplatte 2 sowie an das erste Bestückungselement 5, das zweite Bestückungselement 6, das dritte Bestückungselement 7 und das vierte Bestückungselement 8 angrenzend angeordnet und kontaktiert die Trägerplatten-Grundfläche 3, die Trägerplatten-Deckfläche 4, eine Trägerplatten-Mantelfläche 11, sowie eine erste Bestückungselement-Deckfläche 12 und eine erste Bestückungselement-Mantelfläche 13 des ersten Bestückungselements 5. Die erste Bestückungselement-Mantelfläche 13 grenzt zur Gänze an das Kunststoffgehäuse 9 an.

Ferner kontaktiert das Kunststoffgehäuse 9 weitere Deckflächen und weitere Mantelflächen des zweiten Bestückungselements 6, des dritten Bestückungselements 7 und des vierten Bestückungselements 8, wobei eine Messonden-Deckfläche 14 des vierten Bestückungselements 8 nicht kontaktiert wird.

Erfindungsgemäß kann jedoch auch vorgesehen sein, dass die Messsonde 10 nicht aus dem Kunststoffgehäuse 9 herausragt oder dass das vierte Bestückungselement 8 nicht als Drucksensor ausgeführt ist bzw. keine Messsonde 10 aufweist etc., wodurch das Kunststoffgehäuse 9 auch eine Deckfläche des vierten Bestückungselements 8 vollständig kontaktiert.

Eine Oberfläche 15 des Kunststoffgehäuses 9 ist einem aus der zumindest einen Trägerplatte 2 und dem ersten Bestückungselement 5, dem zweiten Bestückungselement 6 und dem dritten Bestückungselement 7 gebildeten Dickenverlauf oder Höhenverlauf folgend ausgeführt, wobei eine Wandstärke des Kunststoffgehäuses 9 im Bereich des ersten Bestückungselements 5, des zweiten Bestückungselements 6 und des dritten Bestückungselements 7 annähernd konstant ausgeführt ist.

Das Kunststoffgehäuse 9 weist im Bereich der Trägerplatten-Deckfläche 4 eine zylindrische Ausnehmung 16 auf, mittels welcher die Trägerplatte 2 im Bereich der Ausnehmung 16 freigelegt ist. Die Ausnehmung 16 ist im Bereich des vierten Bestückungselements 8 vorgesehen, um dieses von der Trägerplatten-Deckfläche 4 aus zu montieren, zu demontieren und zu warten.

Im Bereich der Ausnehmung 16 ist eine mit der Maschine 1 gekoppelte, als Leuchtdiode ausgeführte Leuchtanzeige 17 auf der Trägerplatten-Deckfläche 4 angeordnet, welche einen Betriebszustand des fluidischen Aktuators anzeigt.

Als Werkstoff für das Kunststoffgehäuse 9 ist ein Polymer vorgesehen, wobei ein Thermoplast mit einer Wärmeleitfähigkeit von 3 W/(m·K) und einem Temperatur-Anwendungsbereich zwischen -40 °C und 155 °C eingesetzt ist. Erfindungsgemäß können jedoch auch Polymere vorgesehen sein, welche eine größere Wärmeleitfähigkeit und einen größeren Temperatur-Anwendungsbereich aufweisen.

Bei dem eingesetzten Thermoplast handelt es sich um Polyamid 66 (PA 66). Erfindungsgemäß sind jedoch auch andere Thermoplaste für das Kunststoffgehäuse 9 anwendbar, beispielsweise Polyphenylensulfid (PPS) oder Polyamid 6 (PA 6) etc.

Im Bereich der Trägerplatten-Grundfläche 3 weist das Kunststoffgehäuse 9 einen Kühlkörper 18 auf, wobei dieser Kühlkörper 18 einstückig mit dem Kunststoffgehäuse 9, als Spritzgussteil gefertigt ist.

Der Kühlkörper 18 weist eine erste Kühlrippe 19 sowie weitere Kühlrippen auf.

Erfindungsgemäß ist es auch denkbar, auf den Kühlkörper 18 zu verzichten und die Oberfläche 15 des Kunststoffgehäuses 9 dem dann auch von dem vierten Bestückungselement 8 gebildeten Dickenverlauf oder Höhenverlauf folgend auszubilden, wobei das Kunststoffgehäuse 9 dann auch im Bereich der Trägerplatten-Grundfläche 3 eine annähernd konstante Wandstärke aufweist. Eine annähernd konstante Wandstärke des Kunststoffgehäuses 9 im Bereich der Trägerplatten-Grundfläche 3 ist insbesondere dann vorstellbar, wenn das vierte Bestückungselement 8 nicht aus dem Kunststoffgehäuse 9 herausragend angeordnet ist.

Im Bereich der Trägerplatten-Grundfläche 3 sind ein als erster Silber-Kontaktstift ausgeführter, elektrischer erster Kontakt 20 sowie in Fig. 1 nicht sichtbare, als weitere Silber-Kontaktstifte ausgebildete weitere elektrische Kontakte mit der Trägerplatte 2 verbunden. Der erste Kontakt 20 und die weiteren Kontakte ragen aus dem Kunststoffgehäuse 9 heraus.

Über den ersten Kontakt 20 und die im Bereich der Trägerplatten-Grundfläche 3 angeordneten weiteren Kontakte ist das elektronische Gerät mit einem Motor 22 des als Hydraulikaktuator ausgebildeten fluidischen Aktuators, d.h. mit der Maschine 1, verbunden.

Im Bereich der Trägerplatten-Deckfläche 4 ist ein als zweiter Silber-Kontaktstift ausgebildeter elektrischer zweiter Kontakt 21 mit der Trägerplatte 2 verbunden und ragt aus dem Kunststoffgehäuse 9 heraus. Über diesen zweiten Kontakt 21 sowie in Fig. 1 nicht sichtbare weitere elektrische Kontakte, die ebenfalls als Silber-Kontaktstifte ausgeführt sind, im Bereich der Trägerplatten-Deckfläche 4 mit der Trägerplatte 2 verbunden sind und aus dem Kunststoffgehäuse 9 herausragen, ist die Trägerplatte 2 mit einer nicht dargestellten Stromversorgung verbunden.

Während eines Fertigungsvorgangs des Kunststoffgehäuses 9 ist die Trägerplatte 2 mit dem bereits montierten ersten Bestückungselement 5, dem zweiten Bestückungselement 6, dem dritten Bestückungselement 7, dem vierten Bestückungselement 8 sowie dem ersten Kontakt 20, dem zweiten Kontakt 21 und den weiteren Kontakten in einer Form, welche einerseits eine Topographie der Trägerplatte 2 mit dem ersten Bestückungselement 5, dem zweiten Bestückungselement 6, dem dritten Bestückungselement 7, dem vierten Bestückungselement 8, dem ersten Kontakt 20, dem zweiten Kontakt 21 und den weiteren Kontakten sowie andererseits die Ausnehmung 16 und den Kühlkörper 18 abbildet, angeordnet und wird mit PA 66 umspritzt. Nach dem Fertigungsvorgang härtet das Kunststoffgehäuse 9 aus und die Form wird entfernt.

Das Kunststoffgehäuse 9 und die Trägerplatte 2 sind zylindrisch ausgeführt. Das Kunststoffgehäuse 9 grenzt stirnseitig über eine thermisch leitfähige Platte 23 an die Maschine 1. Die Platte 23 ist mit dem Kunststoffgehäuse 9 verklemmt.

Das elektronische Gerät ist über eine Klemmverbindung mit der Maschine 1 verbunden. Erfindungsgemäß ist es jedoch auch vorstellbar, Schraubenverbindungen zwischen dem elektronischen Gerät und der Maschine 1 vorzusehen.

Zwischen dem ersten Kontakt 20 und dem Motor 22 der Maschine 1 ist ein erster Leitungsweg 24 vorgesehen, zwischen den im Bereich der Trägerplatten-Grundfläche 3 angeordneten, weiteren Kontakten in Fig. 1 nicht sichtbare weitere Leitungswege.

Der erste Leitungsweg 24 und die weiteren Leitungswege sind innerhalb der Maschine 1, in einem Ringteil 25 der Maschine 1, angeordnet.

Die Maschine 1 bzw. deren Ringteil 25 ist bündig an das elektronische Gerät angeschlossen bzw. schließt bündig mit dem Kunststoffgehäuse 9 ab.

Der Motor 22 ist als bürstenloser Gleichstrom-Elektromotor mit einem ringförmigen Stator 26 und einem Rotor 27 ausgebildet. Der Stator 26 ist in dem Ringteil 25 der Maschine 1 vorgesehen. Über den Stator 26 bzw. dessen Verbindung mit dem elektronischen Gerät wird der Rotor 27, welcher drehbar, aber unverschieblich in der Maschine 1 gelagert ist, angetrieben.

Drehbewegungen des Rotors 27 werden auf einen spindelförmigen Abschnitt einer Kolbenstange 28 übertragen, wodurch die Kolbenstange 28 und ein mit der Kolbenstange 28 verbundener Kolben 29 Translationsbewegungen in Richtung einer Längsachse 30 ausführen.

Die Kolbenstange 28 und der Kolben 29 sind in einem Zylinder 31 der Maschine 1 vorgesehen, welcher von dem Ringteil 25 ummantelt ist. Die Kolbenstange 28 ist über ein in Fig. 1 nicht gezeigtes Lager in dem Zylinder 31 gelagert und geführt, so dass sie Rotations- und Translationsbewegungen ausführen kann.

Zwischen der Kolbenstange 28 und dem Zylinder 31 ist eine in Fig. 1 ebenfalls nicht dargestellte erste Dichtung vorgesehen, um ein Eindringen von Feuchtigkeit und Partikeln etc. in den Zylinder 31 zu verhindern.

Eine Kammer 32, welche von dem beweglichen Kolben 29 und dem Zylinder 31 gebildet ist, ist mit einem Hydraulikfluid gefüllt. Der Zylinder 31 fungiert daher als Gehäuse in Bezug auf dieses Hydraulikfluid.

Die Kammer 32 grenzt unmittelbar an die Platte 23. Das elektronische Gerät grenzt im Bereich des Kühlkörpers 18 an die Platte 23.

Dadurch wird von der Trägerplatte 2 bzw. dem ersten Bestückungselement 5, dem zweiten Bestückungselement 6, dem dritten Bestückungselement 7 und/oder dem vierten Bestückungselement 8 in das Kunststoffgehäuse 9 und in den Kühlkörper 18 übertragene Wärme von dem Kühlkörper 18 über die Platte 23 in die Kammer 32, **d.h.** an das Hydraulikfluid, abgegeben.

Die Kammer 32 ist über eine erste Hydraulikleitung 33 mit einem nicht gezeigten Hydraulikbehälter verbunden, **d.h.** über diesen Hydraulikbehälter mit Hydraulikfluid versorgt. Über eine zweite Hydraulikleitung 34 ist die Kammer 32 mit dem Teleskopstoßdämpfer verbunden. Mittels des Kolbens 29 bzw. eines Drucks des Hydraulikfluids wird eine Dämpfungswirkung des Teleskopstoßdämpfers eingestellt. Hierzu wird mittels des Drucksensors bzw. des vierten Bestückungselements 8, dessen Messsonde 10 in die Kammer 32 ragt, laufend der Druck in der Kammer 32 gemessen.

Zwischen dem vierten Bestückungselement 8 und dem Zylinder 31 ist eine nicht dargestellte zweite Dichtung vorgesehen, um eine Benetzung des Kunststoffgehäuses 9 mit Hydraulikfluid zu verhindern.

Mittels des elektronischen Geräts erfolgt laufend ein Abgleich des gemessenen Drucks mit einem definierten Soll-Druck. Auf Basis einer Differenz zwischen dem gemessenen Druck und dem Soll-Druck wird der Motor 22 von dem elektronischen Gerät über entsprechende Spannungsvorgaben an den Stator 26 geregelt, **d.h.** der Motor 22 wird ein- oder ausgeschaltet oder es wird eine Drehzahl des Rotors 27 eingestellt, um mittels entsprechender Kolbenstellungen und Kolbenbewegungen den Soll-Druck in dem Hydraulikfluid bzw. in dem Teleskopstoßdämpfer zu erreichen bzw. zu halten.

Bei der Ausführung der Maschine 1 als Hydraulikaktuator handelt es sich um eine günstige Lösung. Erfindungsgemäß ist es jedoch auch denkbar, die Maschine 1 beispielsweise als Pneumatikaktuator auszubilden und diesen zur Einstellung von Bremszylinderdrücken in einer Drehgestellbremse eines Schienenfahrzeugs einzusetzen.

### Liste der Bezeichnungen

- 1: Maschine
- 2: Trägerplatte
- 3: Trägerplatten-Grundfläche
- 4: Trägerplatten-Deckfläche
- 5: Erstes Bestückungselement
- 6: Zweites Bestückungselement
- 7: Drittes Bestückungselement
- 8: Viertes Bestückungselement
- 9: Kunststoffgehäuse
- 10: Messsonde
- 11: Trägerplatten-Mantelfläche
- 12: Erste Bestückungselement-Deckfläche
- 13: Erste Bestückungselement-Mantelfläche
- 14: Messsonden-Deckfläche
- 15: Oberfläche
- 16: Ausnehmung
- 17: Leuchtanzeige
- 18: Kühlkörper
- 19: Erste Kühlrippe
- 20: Erster Kontakt
- 21: Zweiter Kontakt
- 22: Motor
- 23: Platte
- 24: Erster Leitungsweg
- 25: Ringteil
- 26: Stator
- 27: Rotor
- 28: Kolbenstange
- 29: Kolben
- 30: Längsachse
- 31: Zylinder
- 32: Kammer
- 33: Erste Hydraulikleitung
- 34: Zweite Hydraulikleitung

## Patentansprüche

1. Elektronisches Gerät, insbesondere Steuergerät, mit zumindest einer bestückten Trägerplatte, wobei ein wärmeleitfähiges Kunststoffgehäuse (9) an die zumindest eine Trägerplatte (2) sowie an zumindest ein erstes Bestückungselement (5) angrenzend angeordnet ist, und wobei das Kunststoffgehäuse (9) zumindest eine Trägerplatten-Grundfläche (3) und eine Trägerplatten-Deckfläche (4) sowie eine erste Bestückungselement-Deckfläche (12) und eine erste Bestückungselement-Mantelfläche (13) kontaktiert, **dadurch gekennzeichnet, dass** eine Oberfläche (15) des Kunststoffgehäuses (9) einem aus der zumindest einen Trägerplatte (2) und dem zumindest ersten Bestückungselement (5) gebildeten Dickenverlauf folgend ausgeführt ist, und dass die zumindest eine Trägerplatte (2) über zumindest einen elektrischen ersten Kontakt (20) so mit einer als fluidischer Aktuator ausgebildeten elektrischen Maschine (1) verbindbar ist, dass von dem ersten Bestückungselement (5) abgegebene Wärme über das Kunststoffgehäuse (9) unmittelbar an ein in der elektrischen Maschine (1) strömendes Fluid abgeführt wird.

2. Elektronisches Gerät nach Anspruch 1, **dadurch gekennzeichnet, dass** das Kunststoffgehäuse (9) eine Trägerplatten-Mantelfläche (11) kontaktiert.

3. Elektronisches Gerät nach Anspruch 1 oder 2, **dadurch gekennzeichnet, dass** die erste Bestückungselement-Mantelfläche (13) zur Gänze an das Kunststoffgehäuse (9) angrenzt.

4. Elektronisches Gerät nach einem der Ansprüche 1 bis 3, **dadurch gekennzeichnet, dass** das Kunststoffgehäuse (9) zumindest eine Ausnehmung (16) aufweist, mittels welcher die zumindest eine Trägerplatte (2) im Bereich der zumindest einen Ausnehmung (16) freigelegt ist.

5. Elektronisches Gerät nach Anspruch 4, **dadurch gekennzeichnet, dass** im Bereich der zumindest einen Ausnehmung (16) eine Leuchtanzeige (17) auf der zumindest einen Trägerplatte (2) angeordnet ist.

6. Elektronisches Gerät nach einem der Ansprüche 1 bis 5, **dadurch gekennzeichnet, dass** das Kunststoffgehäuse (9) in einem Polymer-Werkstoff ausgebildet ist.

7. Elektronisches Gerät nach Anspruch 6, **dadurch gekennzeichnet, dass** der Polymer-Werkstoff als Thermoplast ausgeführt ist.

8. Elektronisches Gerät nach Anspruch 7, **dadurch gekennzeichnet, dass** der Thermoplast eine Wärmeleitfähigkeit von zumindest 3 W/(m·K) aufweist.

9. Elektronisches Gerät nach Anspruch 7 oder 8, **dadurch gekennzeichnet, dass** der Thermoplast einen Temperatur-Anwendungsbereich zwischen -40 °C oder kleiner und 155 °C oder größer aufweist.

10. Elektronisches Gerät nach einem der Ansprüche 1 bis 9, **dadurch gekennzeichnet, dass** das Kunststoffgehäuse (9) einen Kühlkörper (18) aufweist.

11. Elektronisches Gerät nach Anspruch 10, **dadurch gekennzeichnet, dass** der Kühlkörper (18) einstückig mit dem Kunststoffgehäuse (9) ausgebildet ist.

12. Elektronisches Gerät nach Anspruch 10 oder 11, **dadurch gekennzeichnet, dass** der Kühlkörper (18) zumindest eine erste Kühlrippe (19) aufweist.

## Claims

1. Electronic device, in particular control device, with at least one assembled carrier plate, wherein a thermally conductive plastic housing (9) is arranged adjoining the at least one carrier plate (2) and at least one first assembly element (5), and wherein the plastic housing (9) contacts at least a carrier plate base area (3) and a carrier plate top area (4) and a first assembly element top area (12) and a first assembly element lateral area (13), **characterised in that** a surface (15) of the plastic housing (9) is embodied to follow a thickness profile formed of the at least one carrier plate (2) and the at least first assembly element (5), and that the at least one carrier plate (2) can be connected to an electric machine (1) embodied as a fluidic actuator by way of at least one electrical first contact (20) so that heat output by the first assembly element (5) is discharged directly to a fluid flowing in the electric machine (1) by way of the plastic housing (9).

2. Electronic device according to claim 1, **characterised in that** the plastic housing (9) contacts a carrier plate lateral area (11).

3. Electronic device according to claim 1 or 2, **characterised in that** the first assembly element lateral area (13) adjoins the plastic housing (9) entirely.

4. Electronic device according to one of claims 1 to 3, **characterised in that** the plastic housing (9) has at least one recess (16), by means of which the at least one carrier plate (2) is exposed in the region of the at least one recess (16).

5. Electronic device according to claim 4, **characterised in that** an indicator lamp (17) is arranged on the at least one carrier plate (2) in the region of the at least one recess (16).

6. Electronic device according to one of claims 1 to 5, **characterised in that** the plastic housing (9) is embodied in a polymer material.

7. Electronic device according to claim 6, **characterised in that** the polymer material is embodied as a thermoplast.

8. Electronic device according to claim 7, **characterised in that** the thermoplast has a heat conductivity of at least 3 W/(m·K).

9. Electronic device according to claim 7 or 8, **characterised in that** the thermoplast has a temperature application range of between -40 °C or less and 155 °C or greater.

10. Electronic device according to one of claims 1 to 9, **characterised in that** the plastic housing (9) has a heat sink (18).

11. Electronic device according to claim 10, **characterised in that** the heat sink (18) is embodied in one piece with the plastic housing (9).

12. Electronic device according to claim 10 or 11, **characterised in that** the heat sink (18) has at least one first cooling fin (19).

## Revendications

1. Dispositif électronique, en particulier dispositif de commande, comportant au moins une plaque de support équipée, dans lequel un boîtier en plastique thermoconducteur (9) est disposé à côté de la au moins une plaque de support (2) et d'au moins un premier élément d'équipement (5), et dans lequel le boîtier en plastique (9) présente au moins une surface de base de plaque de support (3) et une surface de recouvrement de plaque de support (4) ainsi qu'une première surface de recouvrement d'élément d'équipement (12) et une première surface de gaine d'élément de montage (13), **caractérisé en ce qu'**une surface (15) du boîtier en plastique (9) est réalisée en suivant un profil d'épaisseur formé par la au moins une plaque de support (2) et le au moins un premier élément d'équipement (5), et **en ce que** la au moins une plaque de support (2) peut être reliée à une machine électrique (1) conçue comme actionneur fluidique par l'intermédiaire d'au moins un premier contact électrique (20), de telle sorte que la chaleur émise par le premier élément d'équipement (5) soit transmise directement à un fluide circulant dans la machine électrique (1) à travers le boîtier en plastique (9).

2. Dispositif électronique selon la revendication 1, **caractérisé en ce que** le boîtier en plastique (9) est en contact avec une surface de gaine de plaque de support (11).

3. Dispositif électronique selon la revendication 1 ou 2, **caractérisé en ce que** la première surface de gaine d'élément de montage (13) est entièrement adjacente au boîtier en plastique (9).

4. Dispositif électronique selon l'une des revendications 1 à 3, **caractérisé en ce que** le boîtier en plastique (9) présente au moins un évidement (16), au moyen duquel la au moins une plaque de support (2) est exposée dans la zone de l'au moins un évidement (16).

5. Dispositif électronique selon la revendication 4, **caractérisé en ce qu'**un affichage lumineux (17) est disposé sur la au moins une plaque de support (2) dans la zone du au moins un évidement (16).

6. Dispositif électronique selon l'une des revendications 1 à 5, **caractérisé en ce que** le boîtier en plastique (9) est constitué d'un matériau polymère.

7. Dispositif électronique selon la revendication 6, **caractérisé en ce que** le matériau polymère est un thermoplastique.

8. Dispositif électronique selon la revendication 7, **caractérisé en ce que** le thermoplastique présente une conductivité thermique d'au moins 3 W/(m·K).

9. Dispositif électronique selon la revendication 7 ou 8, **caractérisé en ce que** le thermoplastique présente une plage d'application de température comprise entre -40 °C ou moins et 155 °C ou plus.

10. Dispositif électronique selon l'une des revendications 1 à 9, **caractérisé en ce que** le boîtier en plastique (9) présente un dissipateur thermique (18).

11. Dispositif électronique selon la revendication 10, **caractérisé en ce que** le dissipateur thermique (18) est formé d'une seule pièce avec le boîtier en plastique (9).

12. Dispositif électronique selon la revendication 10 ou 11, **caractérisé en ce que** le dissipateur thermique (18) présente au moins une première ailette de refroidissement (19).
